# EUROPEAN PATENT APPLICATION

(11) **EP 4 783 219 A1**
(43) Date of publication of application: **29.07.2026**
(21) Application number: 26151859.1
(22) Date of filing: 14.01.2026
(51) Int. Cl.: H01H 83/14, H01H 83/22, H02H 3/33, G01R 15/18, H01F 38/30

(54) **SYSTEM ON SENSOR ELECTRICAL PROTECTIVE DEVICE**

(30) Priority: 28.01.2025 US 202519039160
(71) Applicant: Schneider Electric USA, Inc., Boston, MA 02108 (US)
(72) Inventor: SCHROEDER, Jeremy D., Boston, 02108 (US); MELECIO RAMIREZ, Juan Ignacio, Boston, 02108 (US); FISCHELS, Collin Richard, Boston, 02108 (US); VAN VORS, David J., Boston, 02108 (US)
(74) Representative: Openshaw & Co.

(57) **Abstract**

A sensor (130) for an electrical protective device (210) has a printed circuit board assembly (142) mounted on a housing (138) that encloses a current transformer. The printed circuit board assembly (142) has on-board sensor electronics thereon for receiving a current signal from the current transformer. The sensor electronics are configured to detect a condition in one or more primary windings (150) based on the current signal and to generate a signal representative of the detected condition.

## Description

### BACKGROUND

This disclosure relates to a sensor for an electrical protective device and an electrical protective device. Aspects of this disclosure relate to electrical protective devices employing differential sensors such as current transformers (CTs). More specifically, aspect of this disclosure relate to apparatus, systems, and methods for improving performance and reliability of sensors, such as CTs.

Circuit breakers and other electrical protective devices with advanced functions, such as ground fault protection or arc fault protection, typically employ electronic printed circuit board assemblies (PCBAs) and sensors (e.g., CTs). Such components add requirements for current paths within the device that are not be necessary for a thermal/magnetic-only circuit breaker. The need for the additional current paths to accommodate the PCBA and sensor creates manufacturing challenges. For instance, design limitations necessitate placement of the PCBA, which is rigid, in certain locations and in certain orientations within the electrical protective device. Manufacturing of an electrical protective device having a large CT fixed on a large PCBA in the limited space of a miniature circuit breaker, for example, is especially challenging regardless of whether it has flexible or rigid current paths.

In addition, depending on their locations, these current paths may create an electromagnetic pattern that unbalances the output voltage during a loaded ground fault event (load current + ground fault). As a result, sensor output voltage values at specific ground faults deviate from the calibrated values, thus negatively impacting yields and/or performance. For this reason, manufacturing ground fault circuit interrupter (GFCI) circuit breakers and the like with unconstrained current paths can present undesired outcomes.

While conventional methods and systems have generally been considered satisfactory for their intended purpose, there is still a need in the art for improvements. This disclosure provides a solution for this need.

### SUMMARY

Aspects of the present disclosure integrate electronics on a sensor itself to create a robust sensing brick for use in an electrical protective device, such as a circuit breaker, and to enable advanced function circuit breaker design for manufacturing. Utilizing a system on sensor design according to aspects of the present disclosure eliminate many of the manufacturing constraints and improves performance.

In an aspect, a sensor for an electrical protective device comprises a housing and a magnetically permeable core enclosed within the housing. The core has an opening through it that is configured to receive one or more primary windings. A secondary winding wound around the core is configured to magnetically couple to the one or more primary windings received in the core opening and to a generate a current signal indicative of current in the one or more primary windings. The sensor also includes a sensor printed circuit board assembly (PCBA) mounted on the housing. The sensor PCBA has on-board sensor electronics installed thereon for receiving the current signal from the secondary winding indicative of current in the primary winding. The sensor electronics are configured to detect a condition in the one or more primary windings based on the current signal and to generate a signal representative of the detected condition.

In another aspect, an electrical protective device comprises a line conductor, a neutral conductor, and a CT. The CT comprises a housing and a magnetically permeable core enclosed within the housing. The core has an opening through it that is configured to receive the conductors and a winding wound around the core. The winding is configured to magnetically couple to the conductors received in the core opening and to a generate a current signal indicative of current in the conductors. The CT also includes a sensor PCBA mounted on the housing. The sensor PCBA has on-board sensor electronics installed thereon for receiving the current signal from the winding on the core. The sensor electronics are configured to detect a condition in the conductors based on the current signal and to generate a signal representative of the detected condition.

In yet another aspect, a method of manufacturing an electrical protective device comprises enclosing a CT in a housing and mounting a sensor PCBA on the housing. The CT comprises a magnetically permeable core that has an opening through it configured to receive one or more primary windings and a secondary winding wound around the core. The secondary winding is configured to magnetically couple to the one or more primary windings received in the core opening and to a generate a current signal indicative of current in the one or more primary windings. The sensor PCBA has on-board sensor electronics thereon for receiving the current signal from the secondary winding. The sensor electronics are configured to detect a condition in the one or more primary windings based on the current signal and to generate a signal representative of the detected condition.

Other objects and features of the present invention will be in part apparent and in part pointed out herein.

### BRIEF DESCRIPTION OF THE DRAWINGS

FIG. 1 is a perspective view of a CT having conductors passing through a core opening in accordance with an embodiment.
FIG. 2A is a perspective view of a GFCI having a CT disposed therein in accordance with an embodiment.
FIG. 2B is a schematic diagram of the GFCI of FIG. 2A having a hot line and a neutral line passing through a CT in accordance with an embodiment.
FIG. 3 is a top plan view of a sensor assembly in accordance with an embodiment.
FIG. 4 is a perspective view having portions removed of a CT assembly including a printed circuit board assembly in accordance with an embodiment.

Corresponding reference characters indicate corresponding parts throughout the drawings.

### DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected.

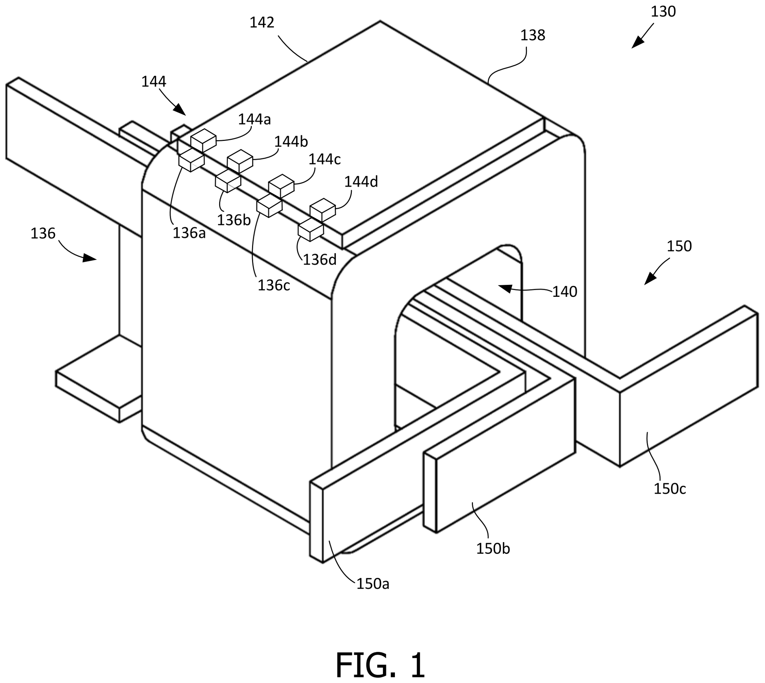

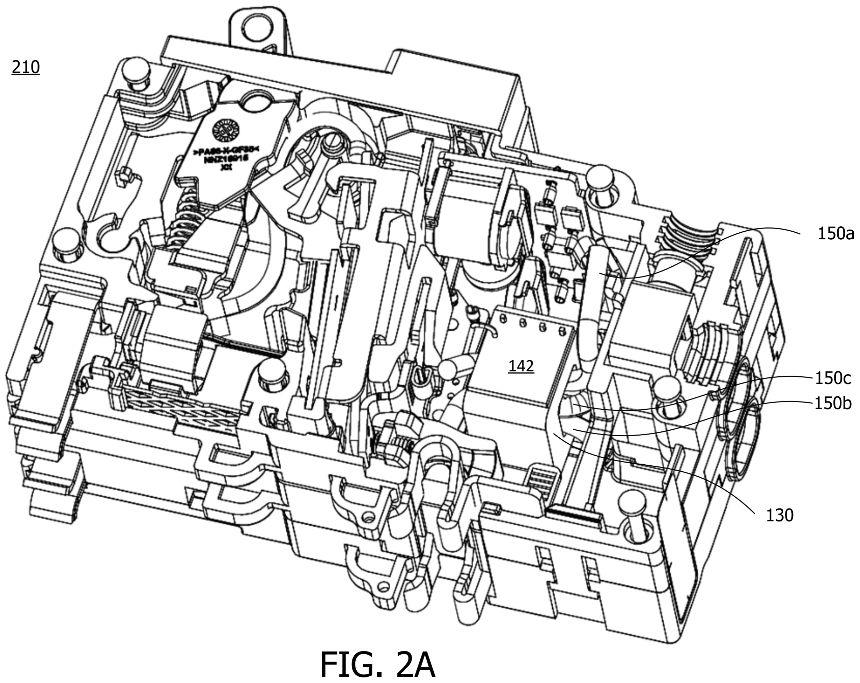

FIG. 1 illustrates an embodiment of a sensor 130 according to aspects of the present disclosure. As shown in FIG. 1, the sensor 130 is embodied by a CT for use in an electrical protective device 210 (see FIG. 2A). The device 210 may be a device or portion thereof configured to perform at least one operation, including a Miniature Circuit Breaker (MCB), a GFCI, or other electronic device or portion thereof in various embodiments, or may be a device or portion of device configured to perform one or more operations corresponding to a GFCI. The sensor 130 can be any suitable shape (e.g., a polygonal closed shape, a circular or toroidal closed shape, etc.). For example, sensor 130 comprises a rectangular closed shape CT as shown in FIG. 1. Although illustrated in the context of a differential sensor, such as a CT, it is to be understood that aspects of the present disclosure may be applied to any system that employs sensors generating signals below the noise floor.

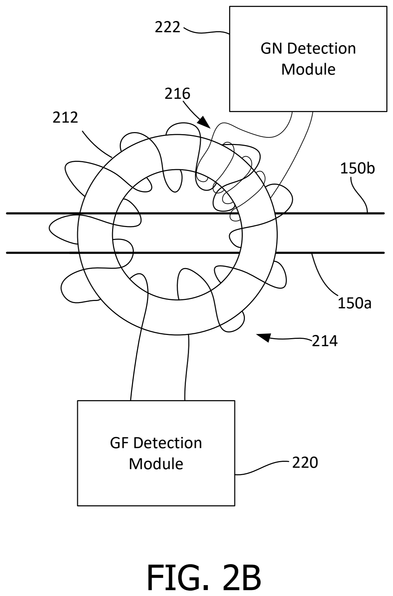

In certain embodiments, sensor 130 of FIG. 1 embodied as a CT includes a terminal 136 (e.g., having first, second, third, and fourth pins 136a, b, c, d, respectively), a housing 138, and a central opening 140 through the housing 138 and the CT's core 212 (see FIG. 2B). In certain embodiments, the pins 136 may include a plurality of pins in various configurations. As described in greater detail below, aspects of the present disclosure provide a system on sensor design having onboard electronics. In the illustrated embodiment, sensor 130 has a sensor PCBA 142 mounted on sensor 130 as shown in FIG. 1. The sensor PCBA 142 contains sensor electronics and includes a terminal 144 (e.g., having first, second, third, and fourth pins 144a, b, c, d, respectively). The terminal 136 of sensor 130 and the terminal 144 of sensor PCBA 142 may be connected together such that each pin 136a, b, c, d is connected to a respective pin 144a, b, c, d. In an embodiment, the sensor PCBA 142 is mounted directly on the housing 138 of sensor 130.

The opening 140 of sensor 130 may be configured to permit one or more conductors 150 and/or other conductor(s) or components (or portions thereof) to pass at least partially therethrough. In the context of sensor 130, the conductors 150 are considered primary windings. In certain embodiments, the first pin 136a and the second pin 136b can be connected to opposing ends of a secondary winding, or sense coil, 214 (see FIG. 2B) wrapping the CT core 212 contained within the housing 138 of sensor 130. The electrical protective device 210 (e.g., GFCI of FIG. 2) includes one or more conductors 150 (e.g., a line, neutral, ground). At least a portion of one or more of the conductors 150 is configured to pass through the opening 140 of sensor 130. Although illustrated with three conductors 150, it should be appreciated that any number of conductors may be configured to pass through at least a portion of the opening 140 in various embodiments without departing from the scope of this disclosure. In the illustrated embodiment of FIG. 1, the conductors 150 are rigid conductors to which line (or L1), ground (or L2), and/or neutral wires may be electrically connected, as indicated at 150a, b, c, respectively. In this regard, FIG. 1 illustrates a partial depiction of an element of sensor 130 (e.g., a CT) having a plurality of current paths passing therethrough according to aspects of this disclosure. In the example of FIG. 1, current flows in L1 and L2, where I1=I2. It is to be understood that one or more embodiments include flexible conductors within the scope of the present disclosure.

As is known in the art, sensor 130 embodied as a CT can include the secondary winding 214 wrapped around core 212 configured to magnetically couple to one or more primary windings, such as a line conductor 150a, a line or ground conductor 150b, and/or a neutral conductor 150c, each passing through the opening 140. The secondary winding 214 is further configured to a generate a current signal indicative of current in the one or more primary windings. In turn, sensor electronics 142 receive the current signal from the secondary winding 214 and detect a condition in the primary winding(s) (i.e., conductors 150) based on the current signal and generate an output signal representative of the detected condition. Such conditions include, for example, those conditions detected by an advanced functions, or smart, MCB or other integrated electronics circuit breaker or the like (e.g., overcurrent, short circuit, overload, ground fault, arc fault, load current, and/or ground-neutral). The core 212 has a passage through it that corresponds to opening 140. The sensor 130 can also include a tertiary winding, or test coil, 216 (see FIG. 2B) wrapped (e.g., partially) around the CT core 212 and configured to magnetically couple to the secondary winding 214 through the core 212 to provide a test signal to the secondary winding 214 in response to a test signal stimulus applied to the tertiary winding 216.

Referring further to FIGS. 2A and 2B, electrical protective device 210, such as a GFCI, can include the sensor 130 in the form of, for example, a CT having a single core 212 (e.g., a toroidal or ring shaped body). The core 212 can be made of a magnetically permeable material (e.g., a ferromagnetic material and/or a nanocrystalline material). In the illustrated embodiment, sensor 130 includes secondary winding 214 wound around the single core 212 (e.g., substantially evenly around the entire circumference of core 212), and tertiary winding 216 wound around the single core 212 (e.g., around only a portion of the circumference of the core 212). Any other suitable winding amount (e.g., 360 degrees, 90 degrees, etc.) for either winding to perform as desired for a desired application is contemplated herein.

In an embodiment, electrical protective device 210 includes a ground fault (GF) detection module 220 operatively connected to secondary winding 214 to receive signals from the secondary winding 214 and configured to determine whether a line-to-ground fault exists. For example, the secondary winding 214 can be configured to output a voltage indicative of a difference in current between a line conductor (e.g., Line 1 conductor 150a) that sends current to the load and a neutral conductor (e.g., neutral conductor 150c) that returns current from the load. When there is no line-to-ground fault, equal and opposite currents in the line conductor 150a and the neutral conductor 150c, for example, substantially cancel out the electromagnetic effect, and no voltage or negligible voltage (e.g., due to winding or conductor placement imperfection) is induced on secondary winding 214. If there is a line-to-ground fault (e.g., current is traveling from line conductor 150a to ground), a threshold voltage can be induced on secondary winding 214 because current returning on neutral conductor 150c is less than that of line conductor 150a. Therefore, the GF detection module 220 can be configured to detect whether voltage from secondary winding 214 is above a threshold to determine whether there is a ground fault. In the illustrated embodiment, conductor 150b represents Line 2 or Ground.

In an embodiment, electrical protective device 210 also includes a ground-neutral (GN) detection module 222 (e.g., similar to GF detection module 220) operatively connected to at least one winding (e.g., the tertiary winding 216) of the sensor 130 and configured to receive signals from tertiary winding 216 to determine whether a neutral-to-ground fault exists. In certain embodiments, the GN detection module 222 operatively connected to tertiary winding 216 provides a GN stimulus signal and is configured to sense changes in impedance (e.g., in the conductors 150a, 150b) to determine whether a neutral-to-ground fault exists.

In accordance with at least one aspect of this disclosure, referring to FIGS. 2A and 2B, the electrical protective device 210 is embodied by a GFCI, for example, that includes one or more primary windings, i.e., conductors 150 (e.g., a line, neutral, or ground) passing through a CT disclosed herein. The conductors 150 pass through opening 140, for example. Again, any suitable number of conductors 150 for any suitable application are contemplated herein (e.g., three as shown). As described above, sensor 130 includes secondary winding 214 wrapped around the CT core 212 configured to magnetically couple to the line conductor 150a and/or 150b and the neutral conductor 150c passing through opening 140. In an alternative embodiment, the conductors 150 are shown in FIGS. 2A and 2B as flexible conductors.

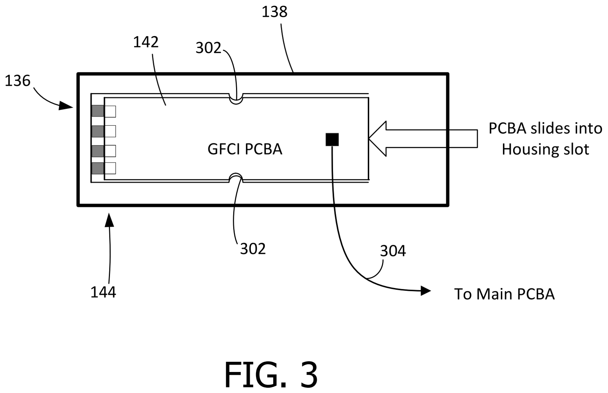

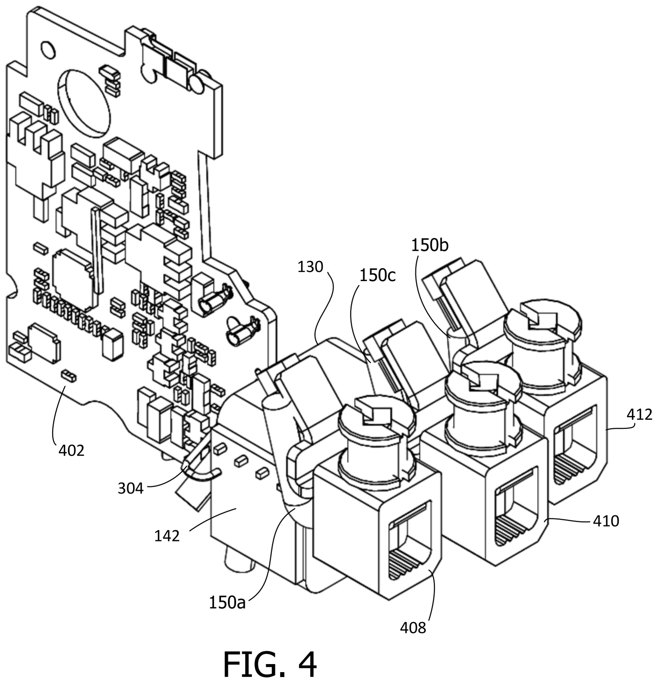

FIG. 3 is a top plan view of sensor 130 in accordance with an embodiment. In the illustrated embodiment, housing 138 includes a flat section for inserting the sensor PCBA 142. For example, sensor PCBA 142 slides into a corresponding receiving area, such as a slot in the housing 138 of sensor 130 in a mating relationship. In an embodiment, housing 138 includes one or more detents 302 or other physical mechanisms for positioning and holding sensor PCBA 142 in relation to the housing 138 of sensor 130. In this embodiment, the detents 302 and corresponding features of sensor PCBA 142 engage in a mating relationship. The sensor PCBA 142 includes a cable connector 304 to a main PCBA (see FIG. 4) of the protective device 210 for signal transmission and/or power. FIG. 3 further illustrates sensor winding termination pins 136 extending from the sensor 130 for electrically connecting to the corresponding pins 144 of sensor PCBA 142 at its edge plating via, for example, a solder dip process.

Aspects of the present disclosure provide a ground fault sensor, such as sensor 130, having electronics on sensor PCBA 142 to allow for transmission of output signals across the flexible cable connector 304. Outputs via connector 304 may be either amplified analog signals or digital outputs. Electronics on sensor PCBA 142 include, among other functionality, amplification and filtering to raise signal levels above noise levels. In an embodiment, electronics on sensor PCBA 142 also include algorithm(s) or other trip decision circuitry to offer a more complete ground fault sensor "brick." Advantageously, such construction in which the sensor electronics of sensor PCBA 142 are resident on the sensor 130 itself enables new manufacturing methods. For example, manufacture of device 210 provides flexibility of placing the sensor PCBA 142 and sensor 130 in different locations and orientations within the casing of the electrical protective device to reduce complexity of manufacturing, create more design options, improve performance, reduce crosstalk, improve signal amplitude, etc. The system on sensor design of the present disclosure also promotes a modular design approach and, in turn, enables a more robust supply chain.

In contrast to the present design, the conventional sensor is traditionally fixed to a main PCBA of the protective device. For example, a typical ground fault CT design has space constraints that limit where the sensor electronics are located within the device. The use of connector 304 in accordance with aspects of the present disclosure permits placement of the sensor electronics on sensor PCBA 142 in a more convenient location within the device 210. The sensor PCBA 142 can then be included in a manufacturing step and the sensor 130 can be included in a later manufacturing step, thus avoiding the requirement of having the sensor present before it is necessary. The sensor 130 can be manipulated throughout the remaining manufacturing process independently of a fixed main PCBA (see FIG. 4). The sensor 130 can also reach a final orientation within electronic protective device 210 that is the most advantageous with respect to the current path independent of a fixed main PCBA (see FIG. 4). Also, relatively low fault current levels are not conducive to being carried over distance because they generate a small analog output signal and, in accordance with one or more embodiments, the sensor electronics of sensor PCBA 142 mounted directly on sensor 130 overcome this problem.

A current path within a conventional electrical protective device requires electrical connection to various other fixed circuit breaker components within the device and must also interface with the sensor in a specific manner. The sensor in a conventional electrical protective device must also interface with the device's main PCBA (see FIG. 4) in a specific manner. These factors combine to add complexity to the manufacturing process and may also prohibit usage of other design elements (e.g., rigid current paths). Advantageously, the system on sensor design embodying aspects of the present disclosure, such as illustrated in FIG. 3, overcomes these manufacturing complexities.

Referring now to FIG. 4, an example manufacturing operation embodying aspects of the present disclosure is shown. As described above, a GF sensor such as sensor 130, includes sensor PCBA 142 having onboard electronics connected via the corded connection of cable 304 for taking in power and outputting either an amplified analog signal or digital output. The example manufacturing operation of FIG. 4 illustrates an example assembly of electrical protective device 210 in which a printed circuit board 402 (i.e., the main PCBA) is sandwiched between plastic mechanical base layers (not shown) and switching mechanisms (not shown) of the electrical protective device 210. In accordance with an embodiment, sensor 130 is electrically connected to a current path Line 1 (e.g., conductor 150a), which is inserted and welded or otherwise attached to a lug base 408 for electrical connection. A first lug mid base 410 is then installed and a neutral current path (e.g., conductor 150c) is inserted and welded to it for electrical connection. A second lug mid base 412 is then installed and a current path Line 2 (e.g., conductor 150b) is inserted and welded or otherwise attached to it for electrical connection. A cover (not shown) protects the entire assembly of sensor PCBA 142.

Referring again to FIG. 1, another example manufacturing operation embodying aspects of the present disclosure is shown. In this embodiment, weld operations may be eliminated by having a one-piece construction involving the circuit breaker mechanism and current path. The conductors 150 are rigid conductors in the illustrated embodiment to which line (or L1), neutral, and/or ground (or L2) wires may be electrically connected, as indicated at 150a, b, c, respectively, which enables various manufacturing options, improved GFCI performance, improved supply chain efficiencies, verification of sensor and electronics components to be delivered, and reduced welding operations.

Commonly assigned U.S. Patent Application No. 18/539,141 and U.S. Patent Application No. 18/902,384, the entire disclosures of which are incorporated herein by reference, each disclose a screening system for a device under test, such as a CT.

Commonly assigned U.S. Patent Application No. 18/125,116, the entire disclosure of which is incorporated herein by reference, discloses a CT for a GFCI.

Commonly assigned U.S. Patent Application No. 18/902,319, the entire disclosure of which is incorporated herein by reference, discloses a shielded CT having a magnetically permeable shield.

Commonly assigned U.S. Patent Application No. 18/902,269, the entire disclosure of which is incorporated herein by reference, discloses an assembly guide for a CT having a grooved shell for facilitating a predetermined winding distribution pattern.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the invention.

When introducing elements of the invention or embodiments thereof, the articles "a," "an," "the," and "said" are intended to mean that there are one or more of the elements. The terms "comprising," "including," and "having" are intended to be inclusive and mean that there may be additional elements other than the listed elements.

Not all of the depicted components illustrated or described may be required. In addition, some implementations and embodiments may include additional components. Variations in the arrangement and type of the components may be made without departing from the scope of the claims as set forth herein. Additional, different or fewer components may be provided and components may be combined. Alternatively, or in addition, a component may be implemented by several components.

The above description illustrates embodiments by way of example and not by way of limitation. This description enables one skilled in the art to make and use aspects of the invention, and describes several embodiments, adaptations, variations, alternatives and uses of the aspects of the invention, including what is presently believed to be the best mode of carrying out the aspects of the invention. Additionally, it is to be understood that the aspects of the invention are not limited in its application to the details of construction and the arrangement of components set forth in the following description or illustrated in the drawings. The aspects of the invention are capable of other embodiments and of being practiced or carried out in various ways. Also, it will be understood that the phraseology and terminology used herein is for the purpose of description and should not be regarded as limiting.

It will be apparent that modifications and variations are possible without departing from the scope of the invention defined in the appended claims. As various changes could be made in the above constructions and methods without departing from the scope of the invention, it is intended that all matter contained in the above description and shown in the accompanying drawings shall be interpreted as illustrative and not in a limiting sense.

In view of the above, it will be seen that several advantages of the aspects of the invention are achieved and other advantageous results attained.

The Abstract and Summary are provided to help the reader quickly ascertain the nature of the technical disclosure. They are submitted with the understanding that they will not be used to interpret or limit the scope or meaning of the claims. The Summary is provided to introduce a selection of concepts in simplified form that are further described in the Detailed Description. The Summary is not intended to identify key features or essential features of the claimed subject matter, nor is it intended to be used as an aid in determining the claimed subject matter.

Further aspects of the invention are provided by the subject matter of the following clauses:
Clause 1. A sensor for an electrical protective device, the sensor comprising: a housing; a magnetically permeable core enclosed within the housing, the core having an opening therethrough configured to receive one or more primary windings; a secondary winding wound around the core, the secondary winding configured to magnetically couple to the one or more primary windings received in the core opening, the secondary winding further configured to a generate a current signal indicative of current in the one or more primary windings; and a sensor printed circuit board assembly (PCBA) mounted on the housing, the sensor PCBA having on-board sensor electronics thereon, the sensor electronics configured to receive the current signal from the secondary winding and configured to detect a condition in the one or more primary windings based on the current signal and to generate an output signal representative of the detected condition.
Clause 2. The sensor of Clause 1, wherein the detected condition is at least a ground fault or an arc fault.
Clause 3. The sensor of Clause 1, wherein the core has a polygonal closed shape, a circular closed shape, or a toroidal closed shape.
Clause 4. The sensor of Clause 3, wherein the polygonal closed shape comprises a rectangular closed shape.
Clause 5. The sensor of Clause 1, wherein the sensor PCBA comprises a plurality of terminals electrically connecting the sensor electronics to the secondary winding.
Clause 6. The sensor of Clause 1, wherein the one or more primary windings comprise at least one of a line conductor, a neutral conductor, or a ground conductor.
Clause 7. The sensor of Clause 1, wherein the one or more primary windings are rigid and in predetermined positions within the core opening.
Clause 8. The sensor of Clause 1, wherein an outer surface of the housing includes an area configured to receive the sensor PCBA.
Clause 9. The sensor of Clause 8, wherein the area comprises a slot and includes one or more detents on an edge thereof configured to engage with the sensor PCBA in a mating relationship when the sensor PCBA is received in the slot.
Clause 10. The sensor of Clause 1, wherein the sensor PCBA comprises a cable connector electrically connecting the sensor electronics to a main PCBA of the electrical protective device.
Clause 11. The sensor of Clause 1, wherein the sensor electronics are configured to provide one or more of the following functionalities: signal amplification, signal filtering, or trip decision-making.
Clause 12. The sensor of Clause 1, further comprising a tertiary winding wound around the core, the tertiary winding configured to generate a test signal in response to a test signal stimulus applied thereto such that the test signal is magnetically coupled to the secondary winding, and wherein the sensor electronics are configured to generate the test signal.
Clause 13. An electrical protective device comprising: a line conductor; a neutral conductor; and a current transformer, the current transformer comprising: a housing; a magnetically permeable core enclosed within the housing, the core having an opening therethrough configured to receive the conductors; a winding wound around the core, the winding configured to magnetically couple to the conductors received in the core opening, the winding further configured to a generate a current signal indicative of current in the conductors; and a sensor printed circuit board assembly (PCBA) mounted on the housing, the sensor PCBA having on-board sensor electronics thereon, the sensor electronics configured to receive the current signal from the winding on the core and configured to detect a condition in the conductors based on the current signal and to generate an output signal representative of the detected condition.
Clause 14. The electrical protective device of Clause 13, wherein the detected condition is at least a ground fault or an arc fault.
Clause 15. The electrical protective device of Clause 13, wherein the sensor PCBA of the current transformer comprises a plurality of terminals electrically connecting the sensor electronics to the secondary winding.
Clause 16. The electrical protective device of Clause 13, wherein the conductors are rigid and in predetermined positions within the core opening.
Clause 17. The electrical protective device of Clause 13, wherein an outer surface of the housing of the current transformer includes an area configured to receive the sensor PCBA of the current transformer.
Clause 18. The electrical protective device of Clause 17, wherein the area comprises a slot and includes one or more detents on an edge thereof configured to engage with the sensor PCBA of the current transformer in a mating relationship when the sensor PCBA of the current transformer is received in the slot.
Clause 19. The electrical protective device of Clause 13, further comprising a main PCBA, and wherein the sensor PCBA of the current transformer comprises a cable connector electrically connecting the sensor electronics of the sensor PCBA to the main PCBA of the electrical protective device.
Clause 20. The electrical protective device of Clause 13, wherein the sensor electronics are configured to provide one or more of the following functionalities: signal amplification, signal filtering, or trip decision-making.
Clause 21. The electrical protective device of Clause 13, wherein the current transformer further comprises another winding wound around the core, the other winding configured to generate a test signal in response to a test signal stimulus applied thereto such that the test signal is magnetically coupled to the winding, and wherein the sensor electronics are configured to generate the test signal.
Clause 22. A method of manufacturing an electrical protective device, the method comprising: enclosing a current transformer in a housing, the current transformer comprising a magnetically permeable core, the core having an opening therethrough configured to receive one or more primary windings, the current transformer further comprising a secondary winding wound around the core, the secondary winding configured to magnetically couple to the one or more primary windings received in the core opening, the secondary winding further configured to a generate a current signal indicative of current in the one or more primary windings; and mounting a sensor printed circuit board assembly (PCBA) on the housing in which the current transformer is enclosed, the sensor PCBA having on-board sensor electronics thereon, the sensor electronics configured to receive the current signal from the secondary winding and configured to detect a condition in the one or more primary windings based on the current signal and to generate an output signal representative of the detected condition.
Clause 23. The method of Clause 22, wherein the conductors are rigid, and further comprising installing the rigid conductors in predetermined positions within the core opening.
Clause 24. The method of Clause 22, wherein the sensor PCBA of the current transformer comprises a plurality of terminals, and further comprising electrically connecting the sensor electronics to the secondary winding via the terminals.

## Claims

1. A sensor (130) for an electrical protective device (210), the sensor (130) comprising:
a housing (138);
a magnetically permeable core (212) enclosed within the housing (138), the core (212) having an opening therethrough configured to receive one or more primary windings (150);
a secondary winding (214) wound around the core (212), the secondary winding (214) being configured to magnetically couple to the one or more primary windings (150) received in the core opening, the secondary winding (214) being configured to a generate a current signal indicative of current in the one or more primary windings (150); and
a sensor printed circuit board assembly, PCBA, (142) mounted on the housing (138), the sensor PCBA (142) having on-board sensor electronics thereon, the sensor electronics being configured to receive the current signal from the secondary winding (214) and configured to detect a condition in the one or more primary windings (150) based on the current signal and to generate an output signal representative of the detected condition.

2. The sensor (130) of claim 1, wherein the detected condition is at least a ground fault or an arc fault.

3. The sensor (130) of claim 1 or claim 2, wherein the core (212) has a polygonal closed shape, a circular closed shape, or a toroidal closed shape.

4. The sensor (130) of any of claims 1 to 3, wherein the sensor PCBA (142) comprises a plurality of terminals (144) electrically connecting the sensor electronics to the secondary winding (214).

5. The sensor (130) of any of claims 1 to 4, wherein the one or more primary windings (150) comprise at least one of a line conductor (150a), a neutral conductor (150c), or a ground conductor (150b).

6. The sensor (130) of any of claims 1 to 5, wherein the one or more primary windings (150) are rigid and in predetermined positions within the core opening.

7. The sensor (130) of any of claims 1 to 6, wherein an outer surface of the housing (138) includes an area configured to receive the sensor PCBA (142).

8. The sensor (130) of claim 7, wherein the area comprises a slot and includes one or more detents (302) on an edge thereof configured to engage with the sensor PCBA (142) in a mating relationship when the sensor PCBA (142) is received in the slot.

9. The sensor (130) of any of claims 1 to 8, comprising a tertiary winding (216) wound around the core (212), the tertiary winding (216) being configured to generate a test signal in response to a test signal stimulus applied thereto such that the test signal is magnetically coupled to the secondary winding (214), and wherein the sensor electronics are configured to generate the test signal.

10. An electrical protective device (210), the electrical protective device (210) comprising:
a line conductor (150a);
a neutral conductor (150c); and
a current transformer (130), the current transformer (130) comprising:
a housing (138);
a magnetically permeable core (212) enclosed within the housing (138), the core (212) having an opening therethrough configured to receive the conductors;
a winding (214) wound around the core (212), the winding being configured to magnetically couple to the conductors (150) received in the core opening, the winding (214) being configured to a generate a current signal indicative of current in the conductors (150); and
a sensor printed circuit board assembly, PCBA, (142) mounted on the housing (138), the sensor PCBA (142) having on-board sensor electronics thereon, the sensor electronics being configured to receive the current signal from the winding (214) on the core (212) and configured to detect a condition in the conductors (150) based on the current signal and to generate an output signal representative of the detected condition.

11. The electrical protective device (210) of claim 10, wherein the sensor PCBA (142) of the current transformer (130) comprises a plurality of terminals (144) electrically connecting the sensor electronics to the winding (214).

12. The electrical protective device (210) of claim 10 or claim 11, wherein the conductors (150) are rigid and in predetermined positions within the core opening.

13. The electrical protective device (210) of any of claims 10 to 12, wherein an outer surface of the housing (138) of the current transformer (130) includes an area configured to receive the sensor PCBA (142) of the current transformer (130).

14. The electrical protective device (210) of claim 13, wherein the area comprises a slot and includes one or more detents (302) on an edge thereof configured to engage with the sensor PCBA (142) of the current transformer (130) in a mating relationship when the sensor PCBA (142) of the current transformer (130) is received in the slot.

15. The electrical protective device of any of claims 10 to 14, wherein the current transformer (130) comprises another winding (216) wound around the core (212), the other winding (216) being configured to generate a test signal in response to a test signal stimulus applied thereto such that the test signal is magnetically coupled to the winding (216), and wherein the sensor electronics are configured to generate the test signal.
